# FASCICULE DE BREVET EUROPEEN

(11) **EP 3 472 121 B1**
(45) Date de publication et mention de la délivrance du brevet: **25.03.2020**
(21) Numéro de dépôt: 17745784.3
(22) Date de dépôt: 14.06.2017
(51) Int. Cl.: C04B 35/107, B32B 9/00, C04B 35/109, C03B 15/00, F01D 5/00

(54) **PROCEDE DE FABRICATION D'UNE PIECE DE TURBOMACHINE**
VERFAHREN ZUR HERSTELLUNG EINER TURBOMASCHINENKOMPONENTE
METHOD FOR MANUFACTURING A TURBOMACHINE COMPONENT

(30) Priorité: 15.06.2016 FR 1655540
(43) Date de publication de la demande: 24.04.2019
(73) Titulaire: Safran Aircraft Engines, 75015 Paris (FR); SAFRAN, 75015 Paris (FR); Centre National de la Recherche Scientifique, 75016 Paris (FR); Université Claude Bernard Lyon 1, 69622 Villeurbanne (FR)
(72) Inventeur: POTELLE, Amélie, 77550 Moissy-Cramayel Cedex (FR); BENAMARA, Omar, 69008 Lyon (FR); LEBBOU, Kheirreddine, 69100 Villeurbanne (FR); PODGORSKI, Michaël, 77550 Moissy-Cramayel Cedex (FR)
(74) Mandataire: Cabinet Beau de Loménie
(86) Numéro de dépôt international: PCT/FR2017/051531
(87) Numéro de publication internationale: WO 2017/216481

(56) Documents cités:
- WO-A1-95/04013
- US-A- 5 573 862
- BELOUET ET AL: "About the crystalline perfection of Nd-doped YAG single crystals", JOURNAL OF CRYSTAL GROWTH, ELSEVIER, AMSTERDAM, NL, vol. 15, no. 3, 1 août 1972 (1972-08-01), pages 188-194, XP024429512, ISSN: 0022-0248, DOI: 10.1016/0022-0248(72)90118-2 [extrait le 1972-08-01]
- BENAMARA OMAR ET AL: "Microstructure and crystallography of Al2O3-Y3Al5O12-ZrO2ternary eutectic oxide grown by the micropulling down t", JOURNAL OF CRYSTAL GROWTH, vol. 429, 26 juillet 2015 (2015-07-26), pages 27-34, XP029273018, ISSN: 0022-0248, DOI: 10.1016/J.JCRYSGRO.2015.07.020
- Hideyuki Yasuda ET AL: "Selection of eutectic systems in AI 2 O 3 -Y 2 O 3 ceramics", Science and Technology of Advanced Materials, vol. 2, no. 1, 30 July 2001 (2001-07-30), pages 67-71, XP055622650, ISSN: 1468-6996, DOI: 10.1016/S1468-6996(01)00027-4
- CHANG K-M ET AL: "Cold-crucible directional solidification of refractory metal-silicide eutectics", JOM 1992 JUN, vol. 44, no. 6, June 1992 (1992-06), pages 59-63,

## Description

### Arrière-plan de l'invention

L'invention concerne un procédé de fabrication d'une pièce de turbomachine en matériau céramique de composition eutectique.

Les superalliages actuellement utilisés pour les pièces de turboréacteurs fortement sollicitées, telles que les aubes de turbine haute pression, ont fait l'objet de développements importants. De tels matériaux peuvent supporter des chargements mécaniques très élevés à relativement haute température. C'est le cas notamment des monocristaux d'alliages base nickel de dernière génération. Toutefois, ces matériaux, même revêtus d'un revêtement de barrière thermique, peuvent ne pas présenter des propriétés optimales pour une utilisation au-delà de 1100°C. D'autres matériaux, comme les céramiques monolithiques oxydes ou non (carbures ou nitrures), ont été développés pour des applications à haute température. Néanmoins, les propriétés mécaniques de ces matériaux peuvent être réduites au-delà de 1300°C. Il peut en être de même pour les composites à matrices céramiques (CMC).

Les matériaux céramiques de composition eutectique constituent, dans ce contexte, une alternative intéressante. En effet, ces matériaux présentent des microstructures qui restent stables jusqu'à leur température de fusion et donc une résistance mécanique quasi-constante jusqu'à cette température, laquelle peut être supérieure à 1700°C pour certaines compositions. En outre, ces matériaux offrent également l'avantage de présenter une densité typiquement comprise entre 4 et 6, c'est-à-dire bien inférieure à la densité des superalliages base nickel coulés laquelle est comprise entre 8,6 et 8,8, permettant ainsi d'alléger la masse des turbomachines.

Toutefois, les procédés de solidification dirigée actuels peuvent ne pas permettre de contrôler de manière satisfaisante la morphologie structurale des matériaux de composition eutectique formés. En effet, au cours de la solidification de ces matériaux, des hétérogénéités de la composition peuvent provoquer l'apparition de colonies ou de cristaux distribués de manière aléatoire dans la matrice ou des ségrégations localisées qui peuvent dégrader les propriétés mécaniques du matériau formé, comme la ténacité et la contrainte de rupture. Il serait donc souhaitable de disposer d'un procédé de solidification dirigée permettant de contrôler de manière fiable la microstructure du matériau céramique de composition eutectique obtenu afin de garantir ses propriétés mécaniques.

Par ailleurs, les procédés actuels utilisés pour la fabrication d'un matériau céramique de composition eutectique peuvent mettre en œuvre un moule de forme complexe (cas du procédé Bridgman) ou une filière en molybdène de géométrie complexe dans le cas du procédé « EFG » (« Edge defined Film fed Growth »). En outre, le procédé Bridgman peut conduire à des contraintes résiduelles dans le cristal formé, voire à la fissuration de ce dernier, et le procédé « EFG » peut être limité en termes d'épaisseur fabricable, rendant ainsi difficile la fabrication d'une pièce ayant un volume suffisant pour constituer une pièce de turbomachine. Il serait, par conséquent, souhaitable de disposer d'un procédé plus simple pour fabriquer, de manière satisfaisante, un tel matériau céramique de composition eutectique destiné à constituer des pièces de turbomachine.

US5573862 divulgue un procédé de fabrication d'une aube de turbomachine comportant la fabrication d'un lingot en YAG, grenat d'aluminium et de yttrium par mise en œuvre du procédé Czochralski.

Il existe donc un besoin pour disposer d'un procédé permettant de fabriquer des pièces de turbomachine en matériau céramique de composition eutectique présentant une microstructure contrôlée et de bonnes propriétés mécaniques à haute température.

Il existe aussi un besoin pour simplifier les procédés existants de fabrication de tels matériaux de composition eutectique.

### Objet et résumé de l'invention

A cet effet, l'invention propose, selon un premier aspect, un procédé de fabrication d'une pièce de turbomachine selon la revendication 1.

L'expression « mélange de composition eutectique » sera dans la suite désignée par « mélange eutectique ».

Les composés céramiques constituant le mélange eutectique peuvent être des céramiques oxyde ou des céramiques non oxyde, par exemple des nitrures ou des carbures.

Le mélange eutectique peut être un mélange binaire, i.e. constitué d'un mélange de deux composés céramiques, ou un mélange ternaire et être dans ce cas constitué d'un mélange de trois composés céramiques. Les composés céramiques constituant le mélange eutectique sont chacun présents en des proportions correspondant aux proportions d'un point eutectique.

Du fait de la mise en œuvre de la technique Czochralski avec des vitesses de tirage et de rotation déterminées, l'invention permet avantageusement de fabriquer une pièce de turbomachine en matériau céramique de composition eutectique présentant une microstructure contrôlée et les propriétés mécaniques souhaitées à chaud (i.e. au-delà de 1100°C, voire au-delà de 1300°C). Un des avantages du procédé Czochralski, lorsqu'il est mis en œuvre avec les valeurs de vitesses de tirage et de rotation décrites ci-dessus, est qu'il permet la ségrégation des défauts de la microstructure sur la périphérie du lingot ce qui permet d'éliminer ces défauts lors de l'étape d'usinage. La rotation imposée au cours de tirage permet en effet d'éjecter les phases parasites vers la périphérie du lingot et d'obtenir, après usinage, une pièce ayant une microstructure homogène. Par ailleurs, l'invention permet avantageusement de fabriquer d'une manière relativement simple des pièces de turbomachine en matériau céramique de composition eutectique lesquelles peuvent avoir une géométrie complexe.

Dans un exemple de réalisation, le mélange eutectique peut comporter de l'alumine (Al₂O₃). Dans un exemple de réalisation, le mélange eutectique peut comporter de la zircone (ZrO₂). La présence de zircone dans le mélange eutectique permet avantageusement d'améliorer davantage encore la ténacité de la pièce obtenue. Dans un exemple de réalisation, le mélange eutectique peut comporter au moins : un oxyde de terre rare, un grenat d'aluminium et de terre rare RE₃Al₅O₁₂ ou une pérovskite REAlO₃, où RE désigne un élément terre rare. L'oxyde de terre rare peut avoir pour formule chimique RE₂O₃ avec RE tel que défini ci-avant et peut par exemple être Y₂O₃ ou La₂O₃.

Le mélange eutectique peut, par exemple, comporter de l'alumine et de la zircone. Dans ce cas, le mélange eutectique peut être binaire ou ternaire.

Le mélange eutectique peut par exemple être choisi parmi les mélanges suivants : Al₂O₃-ZrO₂, Al₂O₃-YAG (YAG correspondant à Y₃Al₅O₁₂), RE₃Al₅O₁₂-Al₂O₃ où RE est un élément terre rare, Al₂O₃-RE₃Al₅O₁₂-ZrO₂ et Al₂O₃-YAG-ZrO₂.

Dans un exemple de réalisation, une vitesse de tirage comprise entre 1 mm/heure et 10 mm/heure peut être imposée au lingot en cours de formation. En particulier, une vitesse de tirage comprise entre 1 mm/heure et 5 mm/heure peut être imposée au lingot en cours de formation.

Dans un exemple de réalisation, il peut être imposé au lingot en cours de formation une vitesse de rotation sur lui-même comprise entre 1 tour/minute et 30 tours/minute. En particulier, il peut être imposé au lingot en cours de formation une vitesse de rotation sur lui-même comprise entre 1 tour/minute et 10 tours/minute.

Dans un exemple de réalisation, la pièce fabriquée peut être une aube de turbomachine.

Dans un exemple de réalisation, la pièce fabriquée peut être un distributeur.

Dans un exemple de réalisation, la pièce fabriquée peut être un secteur d'anneau.

Dans un exemple de réalisation, la pièce fabriquée est une pièce de turbomachine aéronautique. En variante, il s'agit d'une pièce de turbine terrestre.

### Brève description des dessins

D'autres caractéristiques et avantages de l'invention ressortiront de la description suivante de modes particuliers de réalisation de l'invention, donnés à titre d'exemples non limitatifs, en référence aux dessins annexés, sur lesquels :
- la figure 1 est un ordinogramme montrant les étapes mises en œuvre pour la fabrication d'une pièce de turbomachine par un procédé selon l'invention,
- les figures 2A à 2D illustrent schématiquement le tirage d'un lingot en matériau céramique de composition eutectique dans le cadre d'un procédé selon l'invention,
- la figure 3 illustre de manière plus détaillée la formation d'un tel lingot, et
- les figures 4 et 5 sont des photographies de lingots obtenus par mise en œuvre d'un procédé Czochralski dans le cadre d'un procédé selon l'invention.

### Description détaillée de modes de réalisation

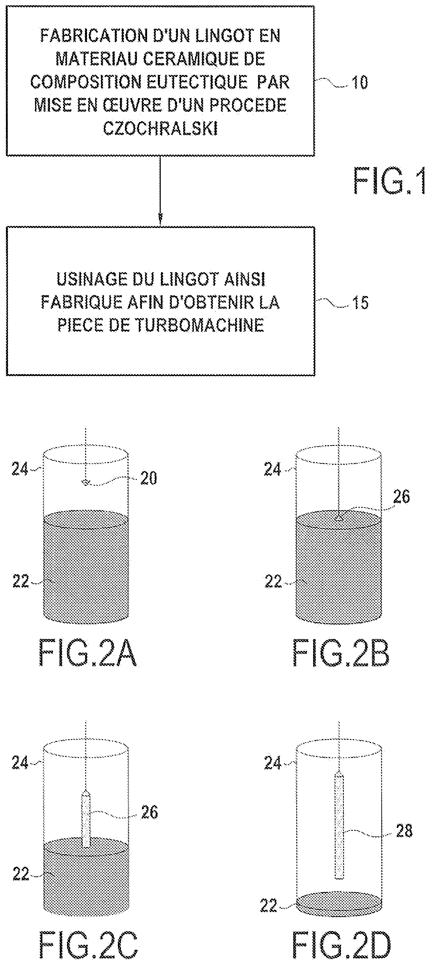

La figure 1 illustre deux étapes. La première étape 10 d'un procédé selon l'invention consiste à fabriquer un lingot en matériau céramique de composition eutectique par mise en œuvre du procédé Czochralski. Des valeurs de vitesse de tirage et de rotation particulières sont mises en œuvre durant cette étape, afin notamment de contrôler la microstructure du lingot obtenu. Ce lingot est ensuite usiné lors d'une deuxième étape 15 afin de former la pièce de turbomachine.

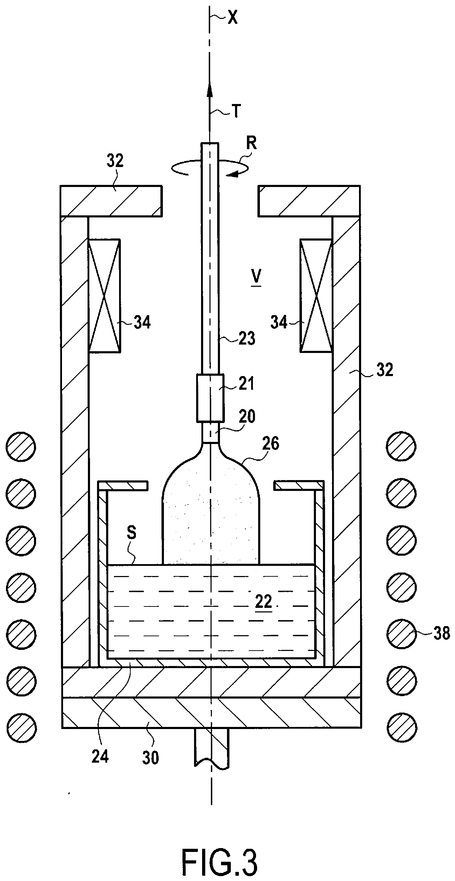

La première étape 10 va à présent être décrite en lien avec les figures 2A à 2D et 3.

Cette première étape met en œuvre un procédé Czochralski durant lequel un germe 20 du matériau céramique de composition eutectique à obtenir est tout d'abord mis en contact avec un bain fondu 22 présent dans un creuset 24 (voir figure 2A). Le germe 20 ainsi que le bain fondu 22 présentent la même composition chimique. Cette composition chimique correspond à la composition du lingot à former. Le germe 20 est légèrement plus froid que le bain fondu 22 (présence d'un gradient thermique à l'interface solide/liquide) ce qui permet d'initier la cristallisation du lingot 26 sur le germe 20 lors de la mise en contact de ce dernier avec le bain fondu 22 (voir figure 2B). Le bain fondu 22 se solidifie sur le germe 20 en gardant la même organisation cristalline que celle du germe 20 (épitaxie). Le tirage du lingot illustré aux figures 2B, 2C et 2D est effectué en imposant au lingot en cours de formation 26 une vitesse de tirage non nulle inférieure ou égale à 10 mm/heure ainsi qu'un mouvement de rotation sur lui-même à une vitesse non nulle inférieure ou égale à 50 tours/minute. Ces vitesses de tirage et de rotation permettent d'obtenir pour le lingot la microstructure recherchée. On obtient après tirage un lingot massif 28 qui est destiné à être usiné afin d'obtenir la pièce de turbomachine. Le lingot obtenu 28 peut avoir une forme cylindrique comme illustré ou, en variante, une forme conique. Le diamètre (plus grande dimension transversale) du lingot obtenu 28 peut, par exemple, être supérieur ou égal à 100 mm. Le diamètre du lingot obtenu 28 peut être modifié en faisant varier la taille du creuset 24. En outre, un rechargement du bain fondu 22 durant le tirage du lingot peut être réalisé. Cela permet avantageusement d'augmenter la longueur du lingot 28 tiré. La formation du lingot 28 est réalisée en l'absence de moule ou de filière à l'inverse des procédés Bridgman ou « EFG ».

La figure 3 illustre le tirage du lingot par la méthode Czochralski de manière plus détaillée. Le germe 20 est initialement mis en contact avec le bain fondu 22 situé dans un creuset 24 en molybdène, platine ou en iridium par exemple. Le creuset 24 est placé sur un plateau support 30. Le choix du matériau du creuset 24 est réalisé afin de disposer d'un creuset 24 supportant les hautes températures mises en œuvre et ne réagissant pas avec le bain fondu 22. Au cours de sa formation, le lingot n'est pas en contact avec le creuset 24 et n'a donc pas besoin d'être démoulé. Le bain 22 est maintenu à l'état fondu par chauffage par un dispositif de chauffage 38, ici une bobine 38 réalisant un chauffage par induction. On pourrait en variante mettre en œuvre un chauffage résistif.

Le germe 20 est présent sur un porte-germe 21 lui-même relié à une tige 23. La tige 23 est reliée à un dispositif de mise en mouvement automatique (non représenté) configuré pour tirer la tige 23 le long de l'axe X dans le sens T et pour simultanément l'entraîner en rotation sur elle-même (mouvement de rotation noté R à la figure 3). Ces mouvements de la tige 23 sont transmis au lingot en cours de formation 26 lequel va ainsi être tiré le long de la direction T et être mis en rotation sur lui-même simultanément à ce tirage.

Le creuset 24 ainsi que le lingot en cours de formation 26 sont présents durant le tirage dans un volume intérieur V défini par une paroi isolante thermique 32. Cette paroi 32 peut présenter sur sa surface interne un ou plusieurs écrans thermiques 34 comme illustré. La paroi isolante thermique 32 et les écrans thermiques 34 permettent de contrôler la température du bain fondu 22 et du lingot en cours de formation 26. On maintient au moins au voisinage de la surface S du bain fondu 22 un gradient thermique selon l'axe de tirage X dans le lingot en cours de formation 26 inférieur ou égal à 50°C/mm, par exemple inférieur ou égal à 10°C/mm. De telles valeurs pour ce gradient thermique peuvent être vérifiées sur une distance au moins égale à 40 mm, voire à 50 mm, à partir la surface S du bain 22. On peut, en particulier, maintenir de telles valeurs pour ce gradient thermique sur une distance comprise entre 40 mm et 50 mm à partir la surface S du bain fondu 22. Par ailleurs, un circuit de refroidissement (non représenté) est présent autour de la paroi isolante 32 et du dispositif de chauffage 38. L'eau peut par exemple être utilisée comme liquide de refroidissement. Il va des connaissances générales de l'homme du métier d'ajuster le chauffage, la nature des isolants thermiques 32 et 34 et le refroidissement à mettre en œuvre afin d'obtenir les valeurs de gradient thermique décrites plus haut.

Comme évoqué plus haut, la formation du lingot est réalisée par tirage à partir d'un bain fondu 22 d'un mélange eutectique comprenant au moins deux composés céramiques différents. Ces composés céramiques peuvent par exemple chacun être des oxydes mais on ne sort pas du cadre de l'invention lorsque ce n'est pas le cas comme mentionné ci-avant. Le mélange eutectique peut ainsi être :
- un mélange eutectique d'oxydes céramiques, ou
- un mélange eutectique de carbures céramiques, ou encore
- un mélange eutectique de nitrures céramiques.

On impose au lingot en cours de formation 26 durant l'étape de tirage une vitesse de tirage constante selon la direction T inférieure ou égale à 10 mm/heure ainsi qu'un mouvement de rotation R autour de l'axe X à une vitesse de rotation constante inférieure ou égale à 50 tours/minute. La direction T et l'axe X sont dans l'exemple illustré perpendiculaires à la surface S du bain fondu 22. La tige 23 est déplacée le long de la direction T et simultanément mise en rotation sur elle-même autour de l'axe X durant l'étape de tirage. De telles valeurs pour les vitesses de tirage et de rotation permettent d'obtenir un régime stationnaire de cristallisation et d'obtenir ainsi la microstructure souhaitée pour la pièce à fabriquer en limitant notamment les germinations parasites susceptibles de provoquer des défauts dégradant les performances mécaniques.

L'atmosphère dans le volume intérieur V peut être une atmosphère inerte (argon, diazote). La pression dans le volume intérieur V peut être inférieure ou égale à la pression atmosphérique (1bar). On peut par exemple utiliser un débit de gaz neutre d'environ 1L/h dans le volume intérieur, ce débit peut toutefois être modifié en fonction de la nature du matériau à obtenir.

Comme mentionné plus haut, le bain fondu 22 peut être réalimenté au fur et à mesure du tirage du lingot afin d'obtenir un lingot de longueur supérieure ce qui permet de fabriquer de manière continue des lingots relativement longs.

Le lingot 28 ainsi cristallisé est ensuite usiné pour obtenir la pièce finale avec la géométrie recherchée. L'usinage peut par exemple être réalisé à partir d'outils diamantés. Comme mentionné plus haut, la mise en œuvre des valeurs de vitesses de tirage et de rotation décrites ci-dessus permettent de concentrer les défauts de la microstructure sur la périphérie du lingot 28 permettant ainsi leur élimination lors de l'étape d'usinage. L'invention permet ainsi de fabriquer de manière relativement simple des pièces chaudes de turbomachine en matériau céramique de composition eutectique mono ou poly-cristallin. Les pièces ainsi fabriquées ont une microstructure contrôlée leur conférant les propriétés mécaniques souhaitées.

### Exemple

### Fabrication d'un lingot Al₂O₃-YAG-ZrO₂ de composition eutectique

Un creuset en iridium ayant les dimensions suivantes : diamètre 60 mm, hauteur 60 mm et épaisseur 1,5 mm a été utilisé. Ce creuset comportait une composition ternaire comprenant Al₂O₃, Y₂O₃ et ZrO₂.

La composition a été fabriquée par mélange des différents constituants dans les proportions suivantes : Al₂O₃ à 65% molaire, Y₂O₃ à 16% molaire et ZrO₂ à 19% molaire suivi d'un frittage à haute température afin d'obtenir un mélange eutectique Al₂O₃-YAG-ZrO₂.

Le mélange eutectique ainsi obtenu a été fondu par chauffage par induction afin de former le bain fondu dans le creuset. Le creuset 24 est présent durant le tirage dans un volume intérieur défini par une paroi isolante thermique munie d'un écran thermique.

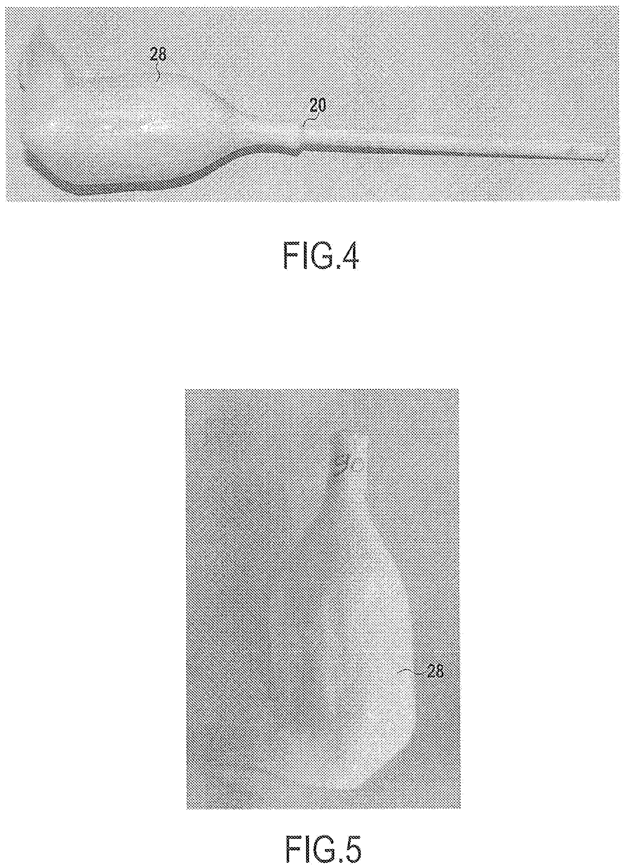

Un germe 20 présentant la même composition que le bain fondu a été mis en contact avec ce dernier afin d'initier la cristallisation du lingot. Le bain fondu a été maintenu à une température proche de 1750°C durant le tirage et le tirage a été effectué dans une atmosphère d'argon. Le germe 20 ainsi que le lingot en cours de formation sur ce dernier ont ensuite été tirés verticalement en imposant une vitesse de tirage de 2 mm/heure et une vitesse de rotation de 2 tours/minute. Un lingot cylindrique 28 présentant un diamètre d'environ 30 mm et une longueur d'environ 60 mm a été obtenu (figure 4). Le lingot 28 ainsi fabriqué était de couleur blanche et ne présentait pas de défauts macroscopiques visibles. Une analyse par diffraction des rayons X à température ambiante (20°C) montre l'existence des trois phases dans le lingot 28 : Al₂O₃, YAG et ZrO₂.

Cet essai a été reproduit plusieurs fois afin de confirmer sa reproductibilité. La figure 5 montre le lingot 28 obtenu après réitération de cet essai.

L'expression « compris(e) entre ... et ... » doit se comprendre comme incluant les bornes.

## Revendications

1. Procédé de fabrication d'une pièce de turbomachine comportant au moins les étapes suivantes :
- fabrication d'un lingot (28) en matériau céramique de composition eutectique par mise en œuvre du procédé Czochralski comprenant les étapes suivantes :
- mise en contact d'un germe (20) du lingot à obtenir avec un bain fondu (22) d'un mélange de composition eutectique afin d'initier la formation du lingot sur le germe (20), ledit mélange comprenant au moins deux composés céramiques,
- tirage du lingot (28) à partir du bain fondu en imposant au lingot en cours de formation (26) une vitesse de tirage inférieure ou égale à 10 mm/heure ainsi qu'un mouvement de rotation sur lui-même à une vitesse inférieure ou égale à 50 tours/minute, et
- usinage du lingot (28) ainsi fabriqué afin d'obtenir la pièce de turbomachie,
et dans lequel le lingot (28) est tiré à partir du bain fondu (22) le long d'un axe de tirage (X), et dans lequel il est maintenu au moins au voisinage d'une surface (S) du bain fondu un gradient thermique selon l'axe de tirage dans le lingot en cours de formation (26) inférieur ou égal à 50°C/mm.

2. Procédé selon la revendication 1, dans lequel le mélange eutectique comporte de l'alumine.

3. Procédé selon la revendication 1 ou 2, dans lequel le mélange eutectique comporte de la zircone.

4. Procédé selon l'une quelconque des revendications 1 à 3, dans lequel le mélange eutectique comporte au moins : un oxyde de terre rare, un grenat d'aluminium et de terre rare RE₃Al₅O₁₂ ou une pérovskite REAlO₃, où RE désigne un élément terre rare.

5. Procédé selon l'une quelconque des revendications 1 à 4, dans lequel le mélange eutectique est choisi parmi les mélanges suivants : Al₂O₃-ZrO₂, Al₂O₃-YAG, RE₃Al₅O₁₂-Al₂O₃ où RE est un élément terre rare, Al₂O₃-RE₃Al₅O₁₂-ZrO₂ et Al₂O₃-YAG-ZrO₂.

6. Procédé selon l'une quelconque des revendications 1 à 5, dans lequel on impose au lingot en cours de formation (26) une vitesse de tirage comprise entre 1 mm/heure et 5 mm/heure.

7. Procédé selon l'une quelconque des revendications 1 à 6, dans lequel on impose au lingot en cours de formation (26) une vitesse de rotation sur lui-même comprise entre 1 tour/minute et 30 tours/minute.

8. Procédé selon l'une quelconque des revendications 1 à 7, dans lequel la pièce fabriquée est une aube de turbomachine.

9. Procédé selon l'une quelconque des revendications 1 à 7, dans lequel la pièce fabriquée est un secteur d'anneau.

10. Procédé selon l'une quelconque des revendications 1 à 7, dans lequel la pièce fabriquée est un distributeur.

## Patentansprüche

1. Verfahren zur Herstellung eines Turbomaschinenteils, das wenigstens die folgenden Schritte umfasst:
- Herstellen eines Barrens (28) aus Keramikmaterial mit eutektischer Zusammensetzung durch Durchführen des Czochralski-Verfahrens, welches die folgenden Schritte umfasst:
- Inkontaktbringen eines Keims (20) des zu erhaltenden Barrens mit einem Schmelzbad (22) einer Mischung mit eutektischer Zusammensetzung, um die Bildung des Barrens auf dem Keim (20) zu initiieren, wobei die Mischung wenigstens zwei keramische Verbindungen umfasst,
- Ziehen des Barrens (28) aus dem Schmelzbad, wobei dem Barren im Laufe der Bildung (26) eine Ziehgeschwindigkeit von weniger als oder gleich 10 mm/Stunde sowie eine Eigenrotationsbewegung mit einer Geschwindigkeit von weniger als oder gleich 50 Umdrehungen/Minute auferlegt werden, und
- Bearbeiten des so hergestellten Barrens (28), um das Turbomaschinenteil zu erhalten,
und wobei der Barren (28) entlang einer Ziehachse (X) aus dem Schmelzbad (22) gezogen wird, und wobei wenigstens in der Nähe einer Oberfläche (S) des Schmelzbades ein Wärmegradient entlang der Ziehachse in dem Barren im Laufe der Bildung (26) von weniger als oder gleich 50 °C/mm aufrechterhalten wird.

2. Verfahren nach Anspruch 1, bei dem die eutektische Mischung Aluminiumoxid umfasst.

3. Verfahren nach Anspruch 1 oder 2, bei dem die eutektische Mischung Zirkoniumoxid umfasst.

4. Verfahren nach einem der Ansprüche 1 bis 3, bei dem die eutektische Mischung wenigstens umfasst: ein Seltenerdoxid, ein Aluminium- und Seltenerd-Granat RE₃Al₅O₁₂ oder ein Perowskit REAlO₃, wobei RE ein Seltenerdelement bezeichnet.

5. Verfahren nach einem der Ansprüche 1 bis 4, bei dem die eutektische Mischung aus den folgenden Mischungen ausgewählt ist: Al₂O₃-ZrO₂, Al₂O₃-YAG, RE₃Al₅O₁₂-Al₂O₃, wobei RE ein Seltenerdelement ist, Al₂O₃-RE₃Al₅O₁₂-ZrO₂ und Al₂O₃-YAG-ZrO₂.

6. Verfahren nach einem der Ansprüche 1 bis 5, bei dem dem Barren im Laufe der Bildung (26) eine Ziehgeschwindigkeit im Bereich zwischen 1 mm/Stunde und 5 mm/Stunde auferlegt wird.

7. Verfahren nach einem der Ansprüche 1 bis 6, bei dem dem Barren im Laufe der Bildung (26) eine Eigenrotationsgeschwindigkeit im Bereich zwischen 1 Umdrehung/Minute und 30 Umdrehungen/Minute auferlegt wird.

8. Verfahren nach einem der Ansprüche 1 bis 7, bei dem das hergestellte Teil eine Turbomaschinenschaufel ist.

9. Verfahren nach einem der Ansprüche 1 bis 7, bei dem das hergestellte Teil ein Ringsektor ist.

10. Verfahren nach einem der Ansprüche 1 bis 7, bei dem das hergestellte Teil ein Leitrad ist.

## Claims

1. A method of fabricating a turbine engine part, the method comprising at least the following steps:
• fabricating an ingot (28) out of ceramic material of eutectic composition by performing the Czochralski process comprising the following steps:
• putting a seed (20) of the ingot that is to be obtained into contact with a molten bath (22) of a mixture of eutectic composition in order to initiate the formation of the ingot on the seed (20), said mixture comprising at least two ceramic compounds;
• drawing the ingot (28) from the molten bath while imposing on the ingot (26) that is being formed a drawing speed less than or equal to 10 mm/h together with rotation at a speed of rotation less than or equal to 50 rpm; and
• machining the ingot (28) as fabricated in this way in order to obtain the turbine engine part,
wherein the ingot (28) is drawn from the molten bath (22) along a drawing axis (X), and wherein a temperature gradient less than or equal to 50°C/mm is maintained in the ingot (26) along the drawing axis, at least in the vicinity of a surface (S) of the molten bath.

2. A method according to claim 1, wherein the eutectic mixture includes alumina.

3. A method according to claim 1 or claim 2, wherein the eutectic mixture includes zirconia.

4. A method according to any one of claims 1 to 3, wherein the eutectic mixture includes at least: a rare earth oxide, an aluminum and rare earth garnet RE₃Al₅O₁₂, or a perovskite REAlO₃, where RE designates a rare earth element.

5. A method according to any one of claims 1 to 4, wherein the eutectic mixture is selected from the following mixtures: Al₂O₃-ZrO₂, Al₂O₃-YAG, RE₃Al₅O₁₂-Al₂O₃ where RE is a rare element, Al₂O₃-RE₃Al₅O₁₂-ZrO₂, and Al₂O₃-YAG-ZrO₂.

6. A method according to any one of claims 1 to 5, wherein the ingot (26) being formed is subjected to a drawing speed lying in the range 1 mm/h to 5 mm/h.

7. A method according to any one of claims 1 to 6, wherein the ingot (26) being formed is subjected to a speed of rotation lying in the range 1 rpm to 30 rpm.

8. A method according to any one of claims 1 to 7, wherein the fabricated part is a turbine engine blade or vane.

9. A method according to any one of claims 1 to 7, wherein the fabricated part is a ring sector.

10. A method according to any one of claims 1 to 7, wherein the fabricated part is a nozzle.
